(19) Europäisches Patentamt / European Patent Office / Office européen des brevets

(11) EP 3 780 300 A1

(12) **EUROPEAN PATENT APPLICATION**
published in accordance with Art. 153(4) EPC

(43) Date of publication:
17.02.2021 Bulletin 2021/07

(51) Int Cl.:
*H01S 5/022* (2021.01)   *G02B 7/02* (2021.01)
*G03B 21/14* (2006.01)

(21) Application number: 18914325.8

(22) Date of filing: 13.04.2018

(86) International application number:
PCT/JP2018/015460

(87) International publication number:
WO 2019/198219 (17.10.2019 Gazette 2019/42)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Mitsubishi Electric Corporation
Tokyo 100-8310 (JP)

(72) Inventor: FUTAMI, Mitsuaki
Tokyo 100-8310 (JP)

(74) Representative: Pfenning, Meinig & Partner mbB
Patent- und Rechtsanwälte
Theresienhöhe 11a
80339 München (DE)

(54) **LASER LIGHT SOURCE DEVICE**

(57)    An object is to provide a technique of achieving a high in-plane mounting density of a laser light source element, and capable of reducing increase in a manufacturing cost and adjusting a position of a lens for each laser light source element with a high degree of accuracy. A laser light source apparatus 1 includes: a base 30; a plurality of semiconductor laser elements 101 to 104 arranged on an upper surface of the base 30 and also on lattice points which are intersection points between an x axis group and a y axis group; a plurality of lenses 41 to 44 parallelizing laser light being output from the plurality of laser light source elements 101 to 104; a spacer 20 disposed on the upper surface of the base 30; and an adhesive agent 50. The spacer 20 includes, for each of the lenses 41 to 44, an annular support surface 20b and a wall 20c, and the wall 20c has a clearance groove 20d formed along a direction connecting diagonal points of the lattice points. A sum of a distance from a side surface of each of the lenses 41 to 44 to a surface of the wall 20c facing the side surface of each of the lenses 41 to 44 and a width of the clearance groove 20d is constant.

F I G.  1

**Description**

Technical Field

The present invention relates to a configuration and a holding structure for incorporating a plurality of laser oscillation elements into a common housing in a laser light source apparatus including a laser oscillation element such as a semiconductor laser element.

Background Art

Recently, a semiconductor laser element attracts attention as a light source of a projection display apparatus such as a projector. The semiconductor laser element has excellent characteristics such as monochromaticity and high directionality of oscillated light and lower power consumption, and is expected as a light source as a replacement for a lamp which is widely distributed currently. However, in the current semiconductor laser element, it is difficult to achieve output required for the projection display apparatus with one element, so that the plurality of laser oscillation elements are generally mounted to constitute a light source of the projection display apparatus.

When the plurality of semiconductor laser elements are mounted to constitute the light source of the projector, the semiconductor laser elements are preferably disposed as close to each other as possible in accordance with a requirement of etendue. The etendue is an amount defined by a product of an area and spread angle (in other words, solid angle) of light flux. The etendue is constant in an optical system, thus the etendue on a light source side is limited by an optical system etendue in a projector. For example, when the etendue on the light source side is large, a ratio of light flux which cannot be effectively used on a projector side increases. The laser oscillation element has a small light emitting area, thus is essentially advantageous in reducing the etendue on the light source side, however, when the plurality of laser oscillation elements are used, they need to be designed to be disposed close to each other to keep the etendue on the light source side small. When a usage efficiency of light can be increased, a whole optical system in the projector can be downsized and a cost of a whole apparatus can be reduced.

Furthermore, the etendue on the light source side need to be small firstly to achieve a high-luminance projector. A reduction in a spread angle of a laser output light is effective as well as the configuration of locating the plurality of laser oscillation elements close to each other, and a high degree of accuracy is required in the position of the laser oscillation elements and control of light distribution of output light from each laser oscillation element. That is to say, a position of a lens means corresponding to each single laser oscillation element is precisely adjusted to reduce a variation of the spread angle, thereby being able to reduce the etendue.

For example, Patent Document 1 discloses a mechanism of adjusting a position of a lens when a holding member of a lens is fixed to the other support member by welding against the problem described above.

Patent Document 2 discloses a technique of using a lens array for a plurality of semiconductor laser elements to improve an in-plane mounting density. Patent Document 2 discloses a mechanism of adjusting a position of a lens array using a lens holder.

Prior Art Documents

Patent Documents

Patent Document 1: Japanese Patent No. 5453927
Patent Document 2: Japanese Patent No. 5835606

Summary

Problem to be Solved by the Invention

Patent Document 1 is disadvantageous in terms of an increase in the in-plane mounting density of the semiconductor laser elements by reason that a lens tube for holding the lens causes a functional limiting condition in arranging the plurality of semiconductor laser elements. The lens needs to be downsized in conformity to the lens tube when the lens tube is downsized for purpose of increasing the in-plane mounting density, and a freedom degree of an optical design decreases.

The lens array is used in Patent Document 2, so that it is difficult to optimize the position of the lens for each semiconductor laser element. When each semiconductor laser element is individually adjusted to the lens array, required is a technique of grasping and minutely moving the energized semiconductor laser element, so that a degree of difficulty is significantly increased and moreover, a connection between the plurality of semiconductor laser elements and a single substrate is hardly achieved.

Furthermore, increase in a manufacturing cost of the apparatus is preferably reduced also in a case where the position of the lens with respect to each semiconductor laser element can be adjusted with a high degree of accuracy.

Thus, it is an object of the present invention to provide a technique of achieving a high in-plane mounting density of a laser light source element, and capable of reducing increase in a manufacturing cost of a laser light source apparatus and adjusting a position of a lens for each laser light source element with a high degree of accuracy.

Means to Solve the Problem

A laser light source apparatus according to the present invention includes: a base whose upper surface is a flat surface; a plurality of laser light source elements arranged on the upper surface of the base and also on lattice points which are intersection points between an x axis group and a y axis group, in which an x axis directed to a direction parallel to the upper surface of the base and a y axis directed to a direction parallel to the upper surface of the base and a direction intersecting with the x axis are arranged, respectively; a plurality of lenses parallelizing laser light being output from the plurality of laser light source elements; a spacer disposed on the upper surface of the base to support the plurality of lenses; and an adhesive agent fixing the plurality of lenses to the spacer, wherein the spacer includes, for each of the lenses, an annular support surface supporting a lower surface of each of the lenses and a wall to which a side surface of each of the lenses is fixed by the adhesive agent, the wall has a clearance groove formed along a direction connecting diagonal points of the lattice points, and a sum of a distance from a side surface of each of the lenses to a surface of the wall facing the side surface of each of the lenses and a width of the clearance groove is constant.

Effects of the Invention

According to the present invention, a laser light source apparatus includes: a base whose upper surface is a flat surface; a plurality of laser light source elements arranged on the upper surface of the base and also on lattice points which are intersection points between an x axis group and a y axis group, in which an x axis directed to a direction parallel to the upper surface of the base and a y axis directed to a direction parallel to the upper surface of the base and a direction intersecting with the x axis are arranged, respectively; a plurality of lenses parallelizing laser light being output from the plurality of laser light source elements; a spacer disposed on the upper surface of the base to support the plurality of lenses; and an adhesive agent fixing the plurality of lenses to the spacer, wherein the spacer includes, for each of the lenses, an annular support surface supporting a lower surface of each of the lenses and a wall to which a side surface of each of the lenses is fixed by the adhesive agent, and the wall has a clearance groove formed along a direction connecting diagonal points of the lattice points.

Accordingly, the laser light source apparatus does not include a lens tube for holding the lens, but the plurality of lenses are fixed to the spacer, thus a high in-plane mounting density in the laser light source element can be achieved. The lens can be grasped along the clearance groove provided in the spacer, thus a position of the lens can be adjusted with a high degree of accuracy.

When the distance from the side surface of each of the lenses to the surface of the wall facing the side surface of each of the lenses is too large, a large amount of adhesive agent is necessary to obtain a desired adhesion strength, thus there is a problem that a cure time of the adhesive agent and a material cost increase. However, according to the present invention, the sum of the distance from the side surface of each of the lenses to the surface of the wall facing the side surface of each of the lenses and the width of the clearance groove is constant. Accordingly, an optimal value of the distance and the width of the clearance groove can be easily found out, thus both the suppression of the increase in the manufacturing cost and the highly accurate position adjustment of the lenses can be achieved.

These and other objects, features, aspects and advantages of the technique disclosed in the specification of the present application will become more apparent from the following detailed description of the present invention when taken in conjunction with the accompanying drawings.

Brief Description of Drawings

[Fig. 1] A perspective view of a laser light source apparatus according to an embodiment 1.
[Fig. 2] A perspective view of a laser light source apparatus from which a spacer and a lens are removed.
[Fig. 3] A cross-sectional view along an A-A line in Fig. 2.
[Fig. 4] A perspective view of a semiconductor laser element.

[Fig. 5] A diagram for explaining an arrangement of the semiconductor laser element.

[Fig. 6] A perspective view of a spacer.

[Fig. 7] An enlarged plan view of a wall of the spacer and a surrounding area thereof.

[Fig. 8] A plan view and a cross-sectional view of the wall of the spacer and the surrounding area before the lens is disposed.

[Fig. 9] A plan view and a cross-sectional view of the wall of the spacer and the surrounding area after the lens is disposed.

[Fig. 10] A perspective view of the laser light source apparatus illustrating a lens adjustment process performed by a lens grasping mechanism.

[Fig. 11] A cross-sectional view along a D-D line in Fig. 10.

[Fig. 12] A drawing illustrating a relationship between a clearance groove and a pitch interval of semiconductor laser elements adjacent to each other.

[Fig. 13] A drawing illustrating a region where output light passes through an output surface of the lens when a laser light source apparatus according to an embodiment 2 is driven.

[Fig. 14] A drawing illustrating a region where output light passes through the output surface of the lens when the laser light source apparatus according to the embodiment 2 is driven.

Description of Embodiment(s)

<Embodiment 1>

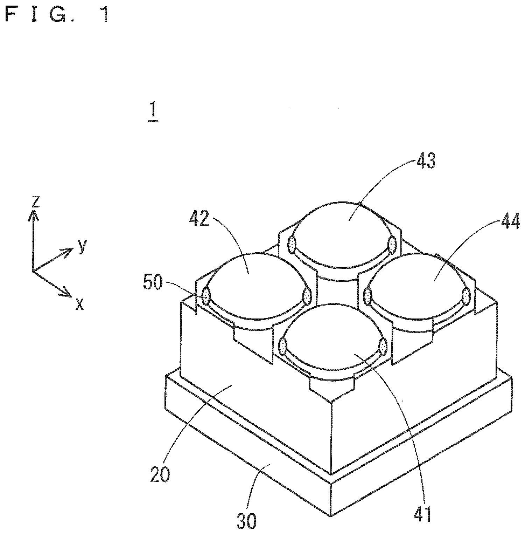

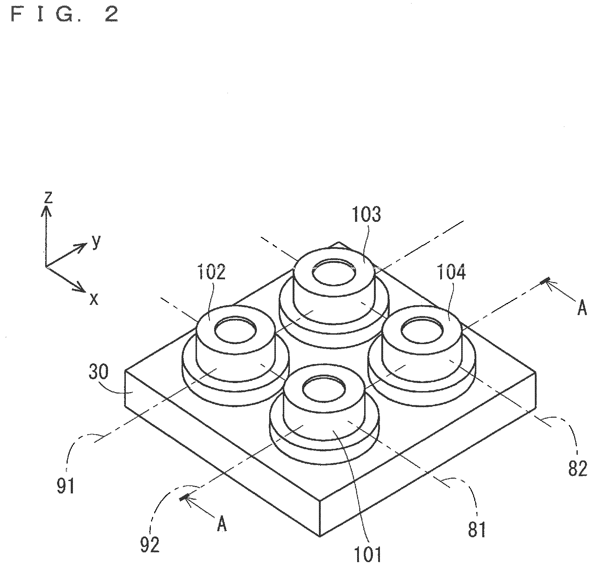

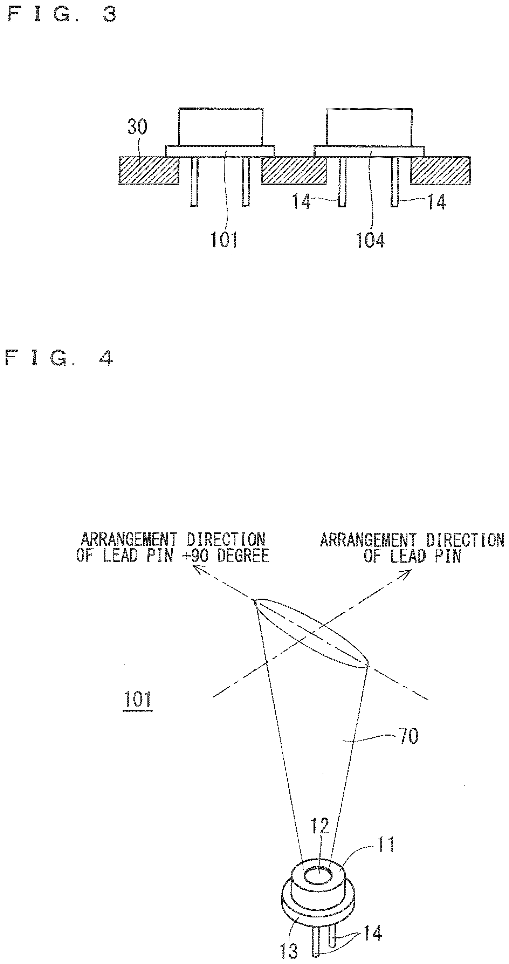

An embodiment 1 according to the present invention is described hereinafter using the drawings. Firstly, a whole configuration of a laser light source apparatus 1 according to the embodiment 1 is described using Fig. 1 to Fig. 3. Fig. 1 is a perspective view of the laser light source apparatus 1 according to the embodiment 1. Fig. 2 is a perspective view of the laser light source apparatus 1 from which a spacer 20 and lenses 41 to 44 are removed. Fig. 3 is a cross-sectional view along an A-A line in Fig. 2.

As illustrated in Fig. 1 to Fig. 3, the laser light source apparatus 1 includes semiconductor laser elements 101 to 104 as laser light source elements, the lenses 41 to 44, the spacer 20, a base 30, and an adhesive agent 50. The laser light source apparatus 1 further includes a drive circuit (not shown) and applies current to the semiconductor laser elements 101 to 104 through the drive circuit to obtain light output in which light is parallelized by the lenses 41 to 44.

Next, the semiconductor laser elements 101 to 104 are described using Fig. 4. Fig. 4 is a perspective view of the semiconductor laser element 101. The semiconductor laser elements 101 to 104 have the same structure, thus the semiconductor laser element 101 is described herein.

As illustrated in Fig. 4, the semiconductor laser element 101 is a TO-Can type package semiconductor laser element, for example. The semiconductor laser element 101 includes a cap 11, a glass window 12, a stem 13, a lead pin 14, and a semiconductor laser chip (not shown) provided on an inner side of the cap 11. A main material of the semiconductor laser chip is a compound semiconductor made of GaAs and InGaN, for example, and the semiconductor laser chip outputs light to the stem 13 in substantially a vertical direction. Generally, an end surface of the semiconductor laser chip is easily broken when moisture and a powder dust in the air adhere to the end surface during driving the semiconductor laser chip. However, an air sealing is maintained by the cap 11 in the TO-Can type package semiconductor laser element, thus a condition required for a driving environment is reduced. The TO-Can type package semiconductor laser element is small in size, thus the number of semiconductor laser elements to be used is easily adjusted, that is to say, light output corresponding to a required specification is easily increased and reduced.

The semiconductor laser element whose end surface emits light has characteristics that a spread of output light in a direction perpendicular to an active layer, that is to say, a direction along a fast axis is approximately ten times as large as that of the output light in a direction horizontal to the active layer, that is to say, a direction along a slow axis. Accordingly, as illustrated in Fig. 4, a cross section of output light 70 in a propagation direction, that is to say, a far-field pattern takes a form of an ellipse. Generally, in the TO-Can package type semiconductor laser element, the active layer of the semiconductor laser element is horizontal to a direction of the two lead pins 14, thus as illustrated in Fig. 4, the spread of the output light in an arrangement direction of the lead pins 14 is small, and the spread of the output light 70 along an axis inclined with respect to the arrangement direction at an angle of 90 degrees is large.

As illustrated in Fig. 1 and Fig. 2, the base 30 is a base mainly made up of a high thermal conductive material such as metal of Cu and Al or a ceramic of SiC and AlN, for example, for supporting the semiconductor laser elements 101 to 104. An upper surface of the base 30 is a flat surface. In the drawings, x, y, and z axes provided for explanation are a rectangular coordinate system, and the x axis is directed to a direction parallel to the upper surface of the base 30. The y axis is directed to a direction parallel to the upper surface of the base 30 and a direction intersecting with the x axis. More specifically, the y axis is directed to a direction parallel to the upper surface of the base 30 and a direction orthogonal to the x axis. The z axis is directed to a direction perpendicular to the upper surface of the base 30.

Bottom surfaces of the semiconductor laser elements 101 to 104 are closely attached and fixed to the upper surface of the base 30 with a thermal conductive grease or a sheet-like heat radiation material therebetween. The semiconductor laser elements 101 to 104 and the base 30 are preferably bonded to each other using a solder material mainly made of SuAgCu or AuSn to further increase heat radiation property. The semiconductor laser elements 101 to 104 have the lead pins 14 for applying the current from an external drive system, thus the base 30 has a thorough hole or a groove to release the lead pins 14.

As illustrated in Fig. 2, straight lines 81 and 82 and straight lines 91 and 92 are virtual lines for describing an arrangement of the semiconductor laser elements 101 to 104 on the base 30. The straight lines 81 and 82 and the straight lines 91 and 92 are lines parallel to the x axis and the y axis, and are located on the upper surface of the base 30. Herein, the straight lines 81 and 82 and the straight lines 91 and 92 intersect with each other. More specifically, the straight lines 81 and 82 and the straight lines 91 and 92 are orthogonal to each other. An interval between the straight line 81 and the straight line 82 and an interval between the straight line 91 and the straight line 92 are equal to each other. That is to say, when the interval between the straight line 81 and the straight line 82 and the interval between the straight line 91 and the straight line 92 are defined as a and b, respectively, a relationship in the following expression (1) is satisfied.

[Math 1]

$$a = b \quad \cdots (1)$$

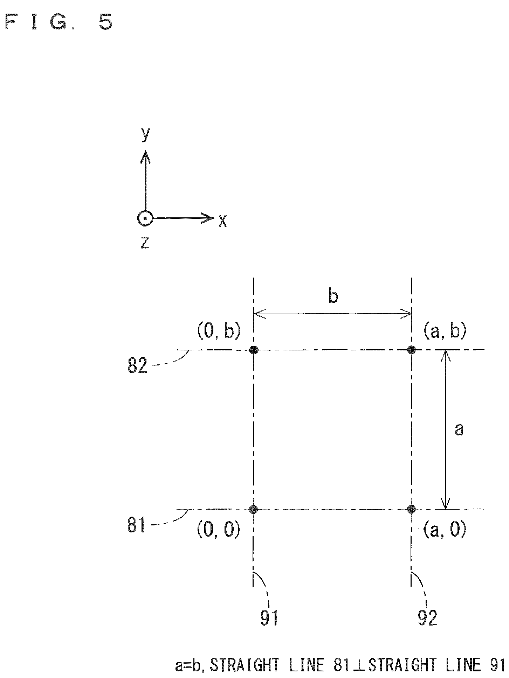

The semiconductor laser elements 101 to 104 are arranged so that luminous points thereof are located on intersection points between the straight lines 81 and 82 and the straight lines 91 and 92, that is to say, on square lattice points to form a surface light source. Fig. 5 is a drawing for explaining the arrangement of the semiconductor laser elements 101 to 104. As illustrated in Fig. 5, when the intersection point between the straight line 81 and the straight line 91 is expressed as $(x, y) = (0, 0)$, the luminous points are located in four points of $(x, y) = (0, 0), (a, 0), (0, b)$, and $(a, b)$.

An arrangement interval between the semiconductor laser elements 101 to 104 at this time, that is to say, an arrangement interval between the lattice points depends on a requirement from a system such as a projector into which the laser light source apparatus 1 is eventually incorporated, however, the arrangement interval is preferably narrow in general in accordance with a requirement of etendue. As the interval between the semiconductor laser elements 101 to 104 is narrow, that is to say, as the light emitting area of the light source is small, the etendue on the light source side can be reduced, thus a usage efficiency of light on a projector apparatus side can be increased. An optical component constituting the projector can be reduced in size, thus the manufacturing cost of the projector can be reduced. The straight lines 81 and 82 correspond to an x axis group, and the straight lines 91 and 92 correspond to a y axis group.

As illustrated in Fig. 1, the lenses 41 to 44 are lenses for parallelizing laser light (also referred to as "output light" hereinafter) being output from the semiconductor laser elements 101 to 104, and each has an axisymmetric spherical surface or aspherical surface as an upper surface. In the semiconductor laser element, particularly in the semiconductor laser element whose end surface emits light, a light output part is extremely small for an oscillation wavelength, thus a spread of beam due to a diffraction effect occurs. Particularly, the spread of the beam in a direction along an epitaxial growth direction of the semiconductor laser chip, that is to say, the spread in a fast axis direction is approximately 60 degree in full angle. Thus, the lenses 41 to 44 having a collimation action are disposed in positions relatively close to the semiconductor laser elements 101 to 104 to keep a beam size substantially constant with respect to an output distance. This is an important requirement for simplifying the optical design of the projector on a subsequent stage.

The output light from the semiconductor laser elements 101 to 104 is approximately 60 degree in full angle, thus the surface of each of the lenses 41 to 44 from which the output light enters is a flat surface or a gentle curved surface with a small curvature. The surface of each of the lenses 41 to 44 from which the output light is output is a curved surface with a large curvature. The reason thereof is that when the parallelization is achieved with one single lens to reduce a component cost of the lenses 41 to 44, a main flat surface of each of the lenses 41 to 44 gets close to an entrance surface, and a shape of the lens in the output surface gets close to a hemispherical shape.

The single lens normally has a concentric shape, and a lens is designed to preferentially correspond to the fast axis direction having a large spread angle. Thus, there is little lens action on the output light in a slow axis direction having a spread angle of approximately 10 degree at a maximum. In order to effectively act on both the fast axis and the slow axis, two lens functions having a focus distance different from each other with respect to the both axes orthogonal to each other need to be concretized with a sole single lens by making the single lens have a function of anamorphic lens, for example, so that such a configuration is hardly achieved from a viewpoint of the component cost.

The TO-Can type package semiconductor laser element has a light emitting size of a laser chip thereof or a package size corresponding to the light output. A package having a diameter of 3.8 mm or 5.6 mm is common as an industry standard, and a package having a diameter of 9 mm is also widely distributed. They indicate a diameter of the stem 13 illustrated in Fig. 4, and become a physical restriction in arranging the TO-Can type package semiconductor laser element on a flat surface.

A package having a stem diameter of 9 mm is described herein. A single lens parallelizing diverging light from each of the semiconductor laser elements 101 to 104 can be disposed at a predetermined interval depending on a package size, that is to say, an interval equal to or larger than the diameter of the stem 13. The spacer 20 holding a collimator lens is a chassis mainly made up of metal or a resin provided to achieve the above configuration. The spacer 20 is fixed to the base 30, to which the semiconductor laser elements 101 to 104 are bonded, by fastening using a screw, adhesion using an adhesive agent, or both of them.

Well known as a modification example of the TO-Can type package semiconductor laser element is an example of a cap with a lens outputting parallel light substituting a lens means for a planar window provided on an upper surface of the cap 11. However, it is difficult to hold a lens having a diameter larger than that of the cap in this case, thus the laser light source apparatus 1 according to the present embodiment 1 is advantageous in that a lens having a larger diameter, that is to say, a lens having a long focus distance can be adopted.

That is to say, when the parallelization is performed with a lens having a larger focus distance for the light emitting size of a predetermined semiconductor laser chip, a degree of parallelism decreases, thus such a lens is advantageous from a viewpoint of the requirement of the etendue. For example, a cap diameter of a package having a diameter of 9 mm is approximately 7 mm, and a lens diameter is set to 5 to 6 mm to secure a sealing property by a lens having a thickness. However, a diameter of the single lens adopted in the present embodiment 1 is approximately 10 mm which is larger than a stem diameter of 9 mm, thus an effect of improving the degree of parallelism equal to or larger than 1.5 times can be expected when the diameter is replaced with the focus distance.

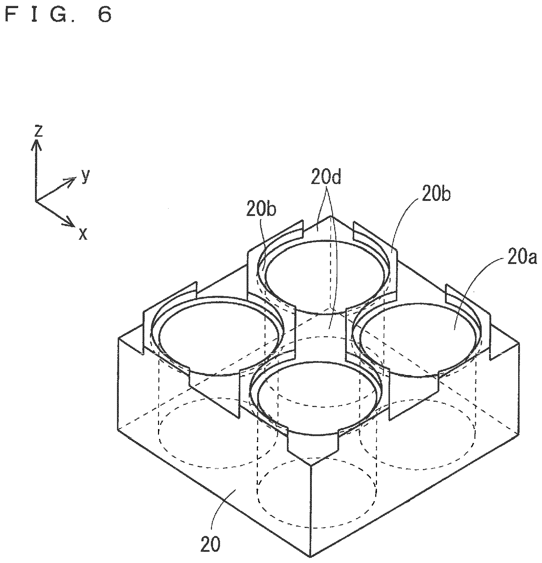

Fig. 6 is a perspective view of the spacer 20. As illustrated in Fig. 6, the spacer 20 includes, for each of the lenses 41 to 44, a space 20a for internally locating the semiconductor laser elements 101 to 104, a support surface 20b provided on a peripheral edge part of an opening in the space 20a toward an upper surface side of the spacer 20, and a wall 20c protruding from the upper surface of the spacer 20 to be located along the support surface 20b. The support surface 20b has an annular shape and supports the lower surfaces of the lenses 41 to 44. The wall 20c covers almost entire side surfaces of the lenses 41 to 44, and the side surfaces of the lenses 41 to 44 are fixed to the wall 20c by the adhesive agent 50. "The opening in the space 20a toward the upper surface side of the spacer 20" is simply referred to as "the opening of the space 20a" hereinafter.

The space 20a has roles of not only internally locating the semiconductor laser elements 101 to 104 in the spacer 20 but also connecting the laser light being output from the semiconductor laser elements 101 to 104 to the lenses 41 to 44. Accordingly, the opening of the space 20a is formed into a circular shape concentric with the lenses 41 to 44 each having the circular shape. That is to say, a dedicated space is provided between the semiconductor laser elements 101 to 104 and the lenses 41 to 44 corresponding thereto, thus stray light caused by a leakage of the laser light from the adjacent semiconductor laser elements 101 to 104 does not occur. A diameter of the opening of the space 20a is smaller than that of each of the lenses 41 to 44 so that the spacer 20 can support the lenses 41 to 44 on the upper surface of the spacer 20. The wall 20c is also formed into a circular shape concentric with the lenses 41 to 44, and the lenses 41 to 44 are internally located in the concentric circle formed by the wall 20c, thus an inner diameter of the wall 20c is larger than the diameter of each of the lenses 41 to 44.

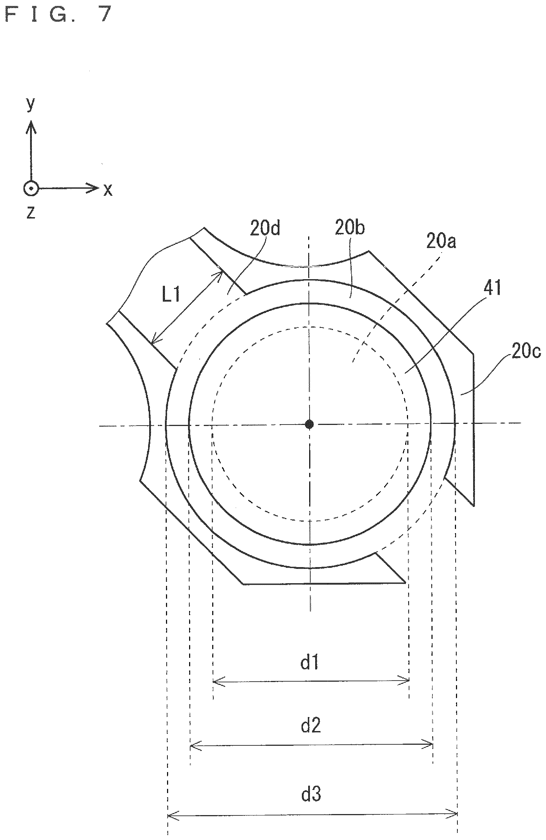

Fig. 7 is an enlarged plan view of the wall 20c of the spacer 20 and a surrounding area thereof. As illustrated in Fig. 7, a magnitude relationship described above is expressed by the following expression (2) when the diameter of the opening of the space 20a is defined as d1, the diameter of the lens 41 is defined as d2, and the inner diameter of the wall 20c is defined as d3.

[Math 2]

$$d1 < d2 < d3 \quad \cdots (2)$$

For example, in a case of a single lens having a diameter of approximately 10 mm, a focus distance can be set to approximately 8 mm. A back focal length in the above case is approximately 5 mm, thus an area needed in a lens entrance surface which the output light spreading at 60 degree in full angle reaches is approximately 6 mm in diameter. The diameter d1 of the opening in the space 20a needs to be set not to be extremely smaller than the diameter d2 of the lens 41 to meet a necessity of efficiently connecting the output light being output from the semiconductor laser elements 101 to 104 to the lens 41. In consideration of a circumstance where a spread angle up to approximately 75 degree in full angle should be allowed depending on the semiconductor laser element, approximately 8 mm at a minimum should be secured as the diameter d1 of the opening in the space 20a.

Considering the above condition, a relationship expressed by the following expression (3) is preferably established between the diameter d1 of the opening in the space 20a and the diameter d2 of the lens 41.

[Math 3]

$$0.8 \times d1 < d2 \quad \cdots(3)$$

The wall 20c is provided to be located along the side surfaces of the lenses 41 to 44, but is not provided to be located along the entire region of the side surfaces of the lenses 41 to 44. As illustrated in Fig. 5 to Fig. 7, in the wall 20c, a clearance groove 20d having a width L1 is provided in a direction connecting diagonal points of the square lattice points where the semiconductor laser elements 101 to 104 are located, that is to say, a direction parallel to a straight line connecting a lattice point (0, b) and a lattice point (a, 0). The clearance groove 20d is necessary to grasp the side surfaces of the lenses 41 to 44 when the lenses 41 to 44 are adjusted to be located in optimal positions on the spacer 20.

The lenses 41 to 44 and the spacer 20 are fixed via the adhesive agent 50. Used as the adhesive agent 50 is an epoxy resin adhesive or an acrylic resin adhesive which is an ultraviolet cure adhesive from a viewpoint of manufacturing the laser light source apparatus 1. The wall 20c has a role of easily and firmly bonding and fixing the lenses 41 to 44 and the spacer 20.

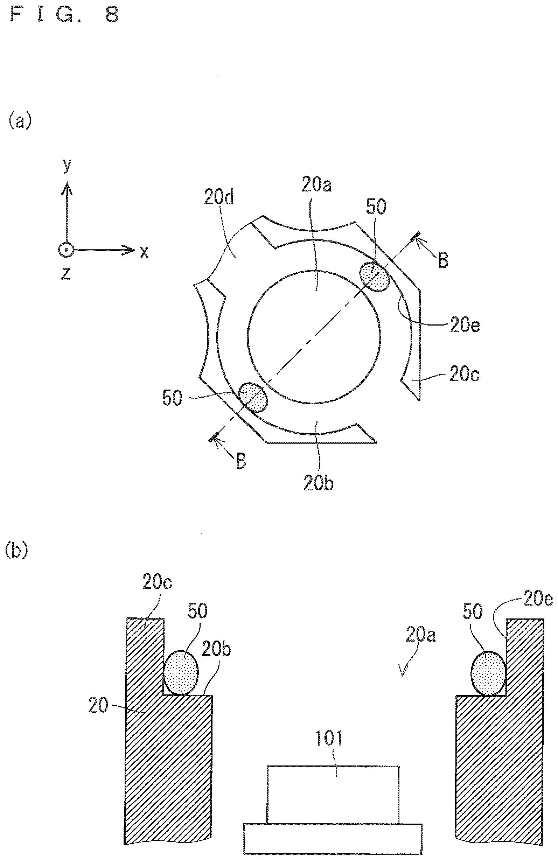

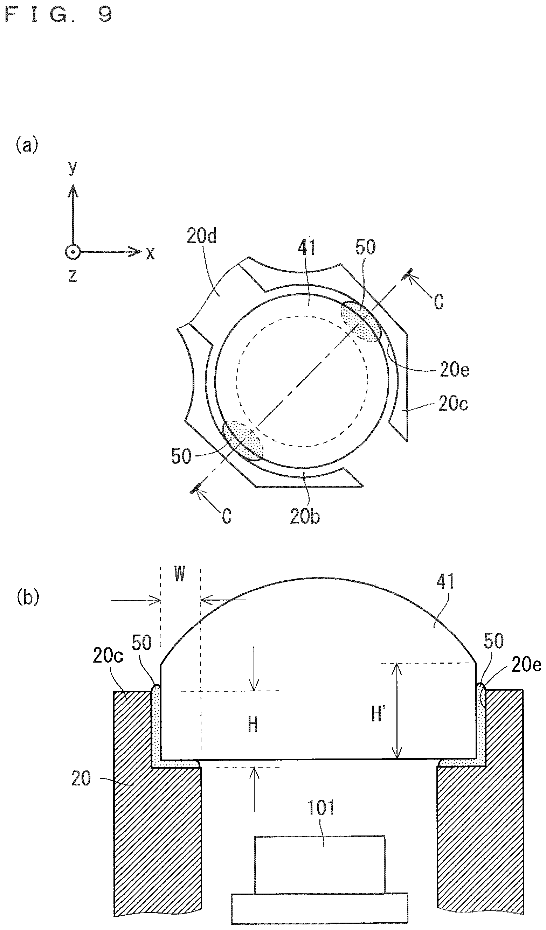

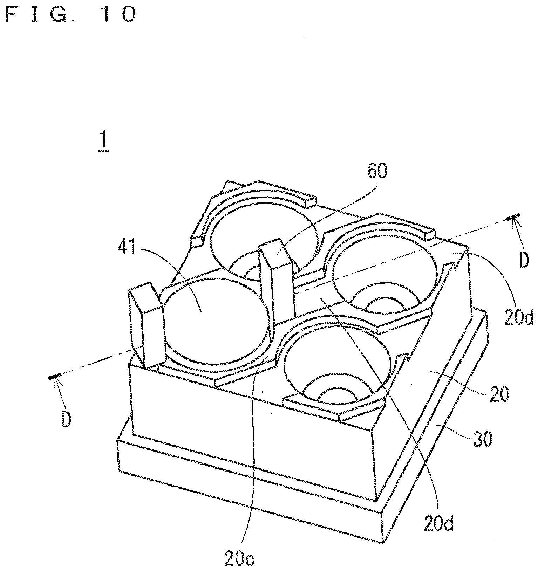

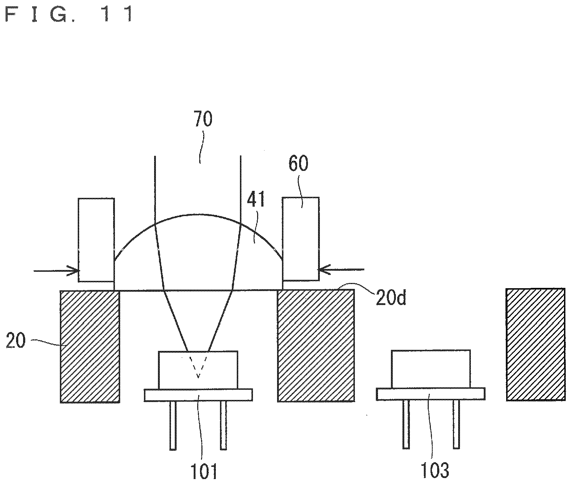

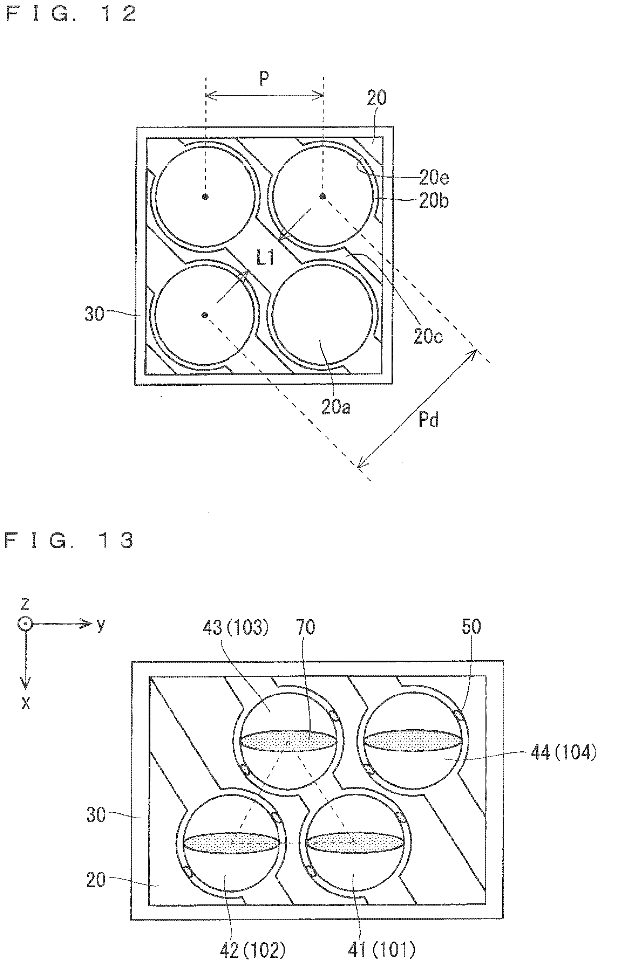

Next, a method of manufacturing the laser light source apparatus 1 is described using Fig. 8 to Fig. 12. Fig. 8(a) is a plan view of the wall 20c of the spacer 20 and the surrounding area thereof before the lens 41 is disposed, and Fig. 8(b) is a cross-sectional view along a B-B line in Fig. 8(a). Fig. 9(a) is a plan view of the wall 20c of the spacer 20 and the surrounding area thereof after the lens 41 is disposed, and Fig. 9(b) is a cross-sectional view along a C-C line in Fig. 9(a). Fig. 10 is a perspective view of the laser light source apparatus 1 illustrating a process of adjusting the lens 41 by a lens grasping mechanism 60. Fig. 11 is a cross-sectional view along a D-D line in Fig. 10. Fig. 12 is a drawing illustrating a relationship between the clearance groove 20d and a pitch interval of semiconductor laser elements 101 to 104 adjacent to each other. The base 30 is omitted in the cross sections to simplify the drawings. A pitch interval P in Fig. 12 is the same as a lattice point interval in Fig. 3.

Firstly, the semiconductor laser elements 101 to 104 are fixed to the base 30. Next, the spacer 20 is fixed to the base 30. As illustrated in Figs. 8(a) and 8(b), the adhesive agent 50 is firstly applied on the support surface 20b of the spacer 20 in a state where the lens 41 is not disposed when the lens 41 is bonded. At this time, the adhesive agent 50 is applied on two positions facing each other with the lens 41 therebetween along an inner peripheral surface 20e of the wall 20c in a direction connecting the diagonal points of the square lattice points where the semiconductor laser element 101 is located, that is to say, a direction parallel to a straight line connecting a lattice point (0, 0) and a lattice point (a, b). Subsequently, the lens 41 is disposed on the spacer 20. The inner peripheral surface 20e of the wall 20c is a surface facing the side surface of the lens 41 in the wall 20c.

At this time, the adhesive agent 50 is sandwiched between the lens 41 and the wall 20c, thereby being peripherally spread, and as a result, as illustrated in Figs. 9(a) and 9(b), the adhesive agent 50 extends into the side surface and the entrance surface of the lens 41. Accordingly, a wide adhesion area can be ensured compared to a case where there is no wall 20c, thus a higher adhesion strength can be obtained. From a viewpoint of ensuring the adhesion strength, it is preferable that a height H of the inner peripheral surface 20e of the wall 20c is set to at least nearly equal to or larger than d3-d1 which is a dimension of a surface on which the lens 41 is put in Fig. 7, that is to say, a dimension W illustrated in Fig. 9(b), and a large difference does not occur between an amount of the adhesive agent 50 extending into the side surface of the lens 41 and an amount of the adhesive agent 50 extending into the entrance surface of the lens 41 to distribute the adhesion of each surface.

When the height H is increased, the adhesion area increases and the adhesion strength increases, however, an influence on formability of the wall 20c and an influence on a manufacturing cost due to increase in a material volume cannot be avoided, thus the height H of the inner peripheral surface 20e of the wall 20c is preferably equal to or smaller than 60 % of a height H' of the side surface of the lens 41.

Subsequently, as illustrated in Fig. 10 and Fig. 11, the lens grasping mechanism 60 is disposed in the clearance groove 20d in the wall 20c, and operates in directions of arrows. The lens grasping mechanism 60 grasps the side surface of the lens 41, and adjusts the position of the lens 41. The position of the lens 41 is adjusted in a state where the lens grasping mechanism 60 grasping the lens 41 moves on the upper surface of the spacer 20 within a range of the upper surface. Furthermore, the position is adjusted while driving the semiconductor laser element 101 by the current and monitoring the output light 70 being output from the lens 41. That is to say, the position is adjusted by fitting a light source image of the output light 70 into a target position which is predetermined on a screen located at a certain distance.

The lens 41 can be moved along an inner diameter of the wall 20c, however, a dimension of the lens grasping mechanism 60 needs to be smaller than the width L1 of the clearance groove 20d. As illustrated in Fig. 12, the width L1 of the clearance groove 20d can be expressed as an expression (4) and moreover, an expression (5) using the pitch interval P of a square lattice arrangement and a pitch interval Pd in a diagonal direction.

[Math 4]

$$Pd = \sqrt{2}P = d3 + L1 + 2 \times \text{minimum value of thickness of wall} \ ... (4)$$

[Math 5]

$$L1 = \sqrt{2}P - d3 - 2 \times \text{minimum value of thickness of wall} \ ... (5)$$

For example, in a case where P = approximately 11 mm, d3 = inner diameter of the wall 20c = the diameter of the lens 41 in 10 mm + α (α corresponds to a gap between the side surface of the lens 41 and the inner peripheral surface 20e), and a minimum value of the thickness of the wall 20c is approximately 0.5 mm, the width L1 of the clearance groove 20d is expressed as

[Math 6]

$$L1 + \alpha = 4.6 \quad \cdots (6)$$

and the width L1 of the clearance groove 20d can be determined from a trade-off of the gap between the side surface of the lens 41 and the inner peripheral surface 20e. When α is too large, a large amount of adhesive agent is necessary to obtain a desired adhesion strength, and a cure time and a material cost increase, thus too large the α is inadvisable. A dimension necessary to adjust the position of the lens 41 is approximately ±10 % of light emitting size of the semiconductor laser chip as a guide, and recognized is that approximately twice a dimension necessary to adjust the position of the lens 41 is sufficient for the α corresponding to the gap between the side surface of the lens 41 and the inner peripheral surface 20e. In the present embodiment 1, α = 0.6 mm, thus L1 is 4 mm. Specifically, it is preferable to determine an optimal value for each numerical parameter in consideration of assembly stability of the actual laser light source apparatus 1 and formability of the wall 20c, for example.

As described above, the laser light source apparatus 1 according to the embodiment 1 includes: the base 30 whose upper surface is the flat surface; the plurality of semiconductor laser elements 101 to 104 arranged on the upper surface of the base 30 and also on the lattice points which are the intersection points between an x axis group and a y axis group, in which the x axis directed to the direction parallel to the upper surface of the base 30 and the y axis directed to the direction parallel to the upper surface of the base 30 and the direction intersecting with the x axis are arranged, respectively; the plurality of lenses 41 to 44 parallelizing the laser light being output from the plurality of semiconductor laser elements 101 to 104; the spacer 20 disposed on the upper surface of the base 30 to support the plurality of lenses 41 to 44; and the adhesive agent 50 fixing the plurality of lenses 41 to 44 to the spacer 20, wherein the spacer 20 includes, for each of the lenses 41 to 44, the annular support surface 20b supporting the lower surfaces of the lenses 41 to 44 and the wall 20c to which the side surfaces of the lenses 41 to 44 are fixed by the adhesive agent 50, and the wall 20c has the clearance groove 20d formed along the direction connecting the diagonal points of the lattice points.

Accordingly, the laser light source apparatus 1 does not include the lens tube for holding the lens, but the plurality of lenses 41 to 44 are fixed to the spacer 20, thus the high in-plane mounting density in the semiconductor laser elements 101 to 104 can be achieved. The lens grasping mechanism 60 is disposed in the clearance groove 20d provided in the spacer 20, and the lenses 41 to 44 can be grasped along the clearance groove 20d by the lens grasping mechanism 60, thus the positions of the lenses 41 to 44 can be adjusted with the high degree of accuracy.

When the distance from the side surfaces of the lenses 41 to 44 to the surface of the wall 20c facing the side surfaces of the lenses 41 to 44, that is to say, to the inner peripheral surface 20e of the wall 20c is too large, a large amount of adhesive agent 50 is necessary to obtain a desired adhesion strength, thus a cure time of the adhesive agent 50 and a material cost increase. However, in the present embodiment 1, a sum of the distance from the side surface of the lens 41 to the inner peripheral surface 20e of the wall 20c and the width of the clearance groove 20e is constant. Accordingly, an optimal value of the distance and the width of the clearance groove 20d can be easily found out, thus both the suppression of the increase in the manufacturing cost of the laser light source apparatus 1 and the highly accurate position adjustment of the lenses 41 to 44 can be achieved.

The adhesion area between the lenses 41 to 44 and the spacer 20 is increased using the wall 20c, thus the fixation strength by the adhesion can be easily increased. The gap between the side surfaces of the lenses 41 to 44 and the inner peripheral surface 20e of the wall 20c is preferably set to approximately twice the dimension necessary to adjust the positions of the lenses 41 to 44, that is to say, twice as large as approximately ±10 % of light emitting size of the semiconductor laser chip. In this case, the width L1 of the clearance groove 20d of approximately 40 % of the diameter of each of the lenses 41 to 44 can be secured. According to the above configurations, the downsizing and the improvement in the durability of the laser light source apparatus 1 can be achieved.

The height of the wall 20c facing the side surfaces of the lenses 41 to 44 is equal to or smaller than 60 % of the height of each of the side surfaces of the lenses 41 to 44, thus the increase in the manufacturing cost of the laser light source apparatus 1 can also be reduced without deteriorating the formability of the wall 20c.

<Embodiment 2>

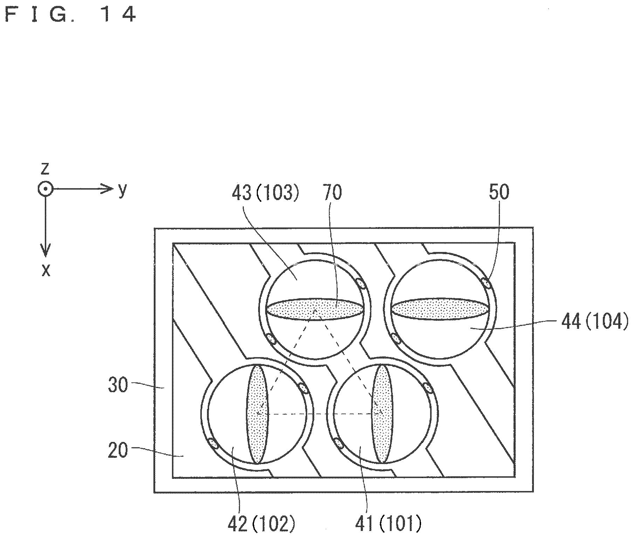

Next, a laser light source apparatus 1 according to an embodiment 2 is described. Fig. 13 and Fig. 14 are drawings each illustrating a region where the output light passes through the output surface of the lens when the laser light source apparatus 1 according to the embodiment 2 is driven. More specifically, Fig. 13 and Fig. 14 are drawings each illustrating an example that the three semiconductor laser elements adjacent to each other are arranged to have a regular triangle relationship indicated by a dotted line in Fig. 13 and Fig. 14, thereby increasing a mounting ratio of the semiconductor laser element per unit of area of the laser light source apparatus 1. In the description of the embodiment 2, the same reference numerals are assigned to the same constituent elements described in the embodiment 1, and the description thereof is omitted.

A close packing of the semiconductor laser element is a typical popularity derived from the requirement of etendue. Thus, in the embodiment 2, as illustrated in Fig. 13 and Fig. 14, the three semiconductor laser elements 101 to 103 adjacent to each other are arranged to have a regular triangle shape when seen from an output direction. The semiconductor laser elements 101 to 103 are disposed on inner sides of the lenses 41 to 43, respectively.

Fig. 13 illustrates an example that all the semiconductor laser elements 101 to 104 are arranged to face the same direction, and all long axes of the output light 70 are parallel to the y axis. Fig. 14 illustrates an example that in the two semiconductor laser elements 103 and 104 on an upper stage, the long axes of the output light 70 are parallel to the y axis, and in the two semiconductor laser elements 101 and 102 on a lower stage, the long axes of the output light 70 are parallel to the x axis. Fig. 13 and Fig. 14 are based on a concept that the etendue of the laser light source apparatus 1 is firstly reduced to improve a usage efficiency of light of a projector. The number and arrangement interval of semiconductor laser elements are parameters which can be flexibly scaled in accordance with a total light output of projector to be needed and an optical design in the projector.

The laser light being output from the laser light source apparatus 1 is collected or separated by an optical means on a subsequent stage, and effectively used in the projector. Thus, the laser light source apparatus 1 with a minimum etendue based on the arrangement having the regular triangle shape illustrated in Fig. 13 and Fig. 14 is not necessarily optimal, and an arrangement in a square lattice form illustrated in the embodiment 1 is preferable in some cases. In any cases, the laser light source apparatus 1 can exert the effect of increasing the usage efficiency of light of the projector with the high flexibility.

As described above, in the laser light source apparatus 1 according to the embodiment 2, the three semiconductor laser elements 101 to 103 adjacent to each other are arranged to have the regular triangle shape when seen from the output direction, thus the mounting ratio of the semiconductor laser element per unit of area of the laser light source apparatus 1 can be increased to make the etendue of the laser light source apparatus 1 get close to minimum.

<Other modification example>

In each of the lenses 41 to 44, the entrance surface needs not necessarily be formed into the flat surface, but may be formed into a curved shape of concave or convex shape. However, the entrance surface of each of the lenses 41 to 44 is preferably formed into the flat surface in a range in which the entrance surface may have contact with the upper surface of the spacer 20 in the lenses 41 to 44 in the process of aligning the lenses 41 to 44 within the range of the upper surface of the spacer 20 parallel to the x axis and the y axis.

Each of the output surface and the entrance surface of the lenses 41 to 44 needs not be the axisymmetric curved surface, however, a cylindrical lens may also be applied so that the output surface or the entrance surface has a shape of parallelizing the output light being output from the semiconductor laser elements 101 to 104 only in the fast axis direction, for example.

The position where the adhesive agent 50 is applied needs not necessarily be located on an extended line in the direction connecting the diagonal points of the lattice points where the semiconductor laser elements 101 to 104 are located, however, the adhesive agent 50 may be applied in any position outside the region where the output light 70 being output from the semiconductor laser elements 101 to 104 passes through the output surfaces of the lenses 41 to 44.

Although the present invention is described in detail, the foregoing description is in all aspects illustrative and does not restrict the invention. It is therefore understood that numerous modifications and variations can be devised without departing from the scope of the invention.

According to the present invention, the above embodiments can be arbitrarily combined, or each embodiment can be appropriately varied or omitted within the scope of the invention.

Explanation of Reference Signs

1 laser light source apparatus, 20 spacer, 20b support surface, 20c wall, 20d clearance groove, 30 base, 41 to 44 lens, 50 adhesive agent, 101 to 104 semiconductor laser element.

**Claims**

1. A laser light source apparatus, comprising:

   a base (30) whose upper surface is a flat surface;
   a plurality of laser light source elements (101 to 104) arranged on the upper surface of the base (30) and also on lattice points which are intersection points between an x axis group and a y axis group, in which an x axis directed to a direction parallel to the upper surface of the base (30) and a y axis directed to a direction parallel to the upper surface of the base (30) and a direction intersecting with the x axis are arranged, respectively;
   a plurality of lenses (41 to 44) parallelizing laser light being output from the plurality of laser light source elements (101 to 104);
   a spacer (20) disposed on the upper surface of the base (30) to support the plurality of lenses (41 to 44); and
   an adhesive agent (50) fixing the plurality of lenses (41 to 44) to the spacer (20), wherein
   the spacer (20) includes, for each of the lenses (41 to 44), an annular support surface (20b) supporting a lower surface of each of the lenses (41 to 44) and a wall (20c) to which a side surface of each of the lenses (41 to 44) is fixed by the adhesive agent (50),
   the wall (20c) has a clearance groove (20d) formed along a direction connecting diagonal points of the lattice points, and
   a sum of a distance from a side surface of each of the lenses (41 to 44) to a surface of the wall (20c) facing the side surface of each of the lenses (41 to 44) and a width of the clearance groove (20d) is constant.

2. The laser light source apparatus according to claim 1, wherein
   a height of the surface of the wall (20c) facing the side surface of each of the lenses (41 to 44) is equal to or smaller than 60 % of a height of the side surface of each of the lenses (41 to 44).

3. The laser light source apparatus according to claim 1, wherein
   the plurality of laser light source elements (101 to 104) include at least three laser light source elements (101 to 104), and
   the three laser light source elements (101 to 103) adjacent to each other of the at least three laser light source elements (101 to 104) are arranged to have a regular triangle shape when seen from an output direction.

FIG. 1

FIG. 2

F I G. 3

F I G. 4

ARRANGEMENT DIRECTION
OF LEAD PIN +90 DEGREE

ARRANGEMENT DIRECTION
OF LEAD PIN

101

70

12

11

14

13

F I G. 5

a=b, STRAIGHT LINE 81⊥STRAIGHT LINE 91

F I G. 6

FIG. 7

F I G. 8

(a)

20d    20a    50

y
↑
⊙ → x
z
              B

              20e

              20c

50

B

20b

(b)

20c    50    20e
       20b
              50    20a
20              20

       101

# F I G. 9

(a)

(b)

F I G. 1 0

1

FIG. 11

FIG. 12

FIG. 13

FIG. 14

## INTERNATIONAL SEARCH REPORT

| International application No. |
| --- |
| PCT/JP2018/015460 |

**A. CLASSIFICATION OF SUBJECT MATTER**
Int.Cl. H01S5/022(2006.01)i, G02B7/02(2006.01)i, G03B21/14(2006.01)i

According to International Patent Classification (IPC) or to both national classification and IPC

**B. FIELDS SEARCHED**

Minimum documentation searched (classification system followed by classification symbols)
Int.Cl. H01S5/022, G02B7/02, G03B21/14

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2017/017864 A1 (MITSUBISHI ELECTRIC CORPORATION) 02 February 2017, paragraphs [0053]-[0058], [0131]-[0134], fig. 1, 2, 10 (Family: none) | 1-3 |
| A | WO 2016/186048 A1 (MITSUBISHI ELECTRIC CORPORATION) 24 November 2016, entire text, all drawings (Family: none) | 1-3 |
| A | JP 2013-196946 A (CASIO COMPUTER CO., LTD.) 30 September 2013, entire text, all drawings (Family: none) | 1-3 |

☒ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 14.06.2018 | 26.06.2018 |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2018/015460

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2017-138566 A (SEIKO EPSON CORPORATION) 10 August 2017, entire text, all drawings (Family: none) | 1-3 |
| A | JP 5-113545 A (ROHM CO., LTD.) 07 May 1993, entire text, all drawings & US 5617441 A & DE 4235549 A1 | 1-3 |
| A | US 2017/0227760 A1 (HAND HELD PRODUCTS, INC.) 10 August 2017, entire text, all drawings & CN 205880874 U | 1-3 |

Form PCT/ISA/210 (continuation of second sheet) (January 2015)

**EP 3 780 300 A1**

**Patent documents cited in the description**

- JP 5453927 B
- JP 5835606 B